Europäisches Patentamt

European Patent Office

Office européen des brevets

(11) Publication number: **0 371 575**
**A2**

## EUROPEAN PATENT APPLICATION

(21) Application number: **89302600.5**

(22) Date of filing: **16.03.89**

(51) Int. Cl.5: **H03K 19/094**

(30) Priority: **23.11.88 US 276199**

(43) Date of publication of application:
**06.06.90 Bulletin 90/23**

(84) Designated Contracting States:
**DE FR GB IT NL**

(71) Applicant: **PRECISION MONOLITHICS INC.**
**1500 Space Park Drive**
**Santa Clara California 95052(US)**

(72) Inventor: **Smith, Douglas S.**
**125 Connemara Way nr. 165**
**Sunnyvale California 94087(US)**
Inventor: **Bowers, Derek F.**
**1502 Harrison Court**
**Sunnyvale California 94087(US)**

(74) Representative: **Crawford, Andrew Birkby et al**
**A.A. THORNTON & CO. Northumberland**
**House 303-306 High Holborn**
**London WC1V 7LE(GB)**

(54) **Improved direct coupled fet logic.**

(57) An (improved) direct coupled logic (DCFL) circuit achieves a full output swing of almost 0.7 volts with GaAs, and yet requires only two reference voltage levels ( + V, -V). The circuit has a first switching FET (T10) supplied by a current source (T9, K1), an output line (2), and an output circuit (D3, T11) which effectively decouples the output line from the first FET (T10) and connects it to a low voltage reference when a logic "high" signal is applied to the input of the switching transistor. The output circuit consists of a voltage drop element, in the form of a Schottky diode (D3), in series with a second FET (T11). The gates of the two FETs (T10, T11) are connected in common, and the circuit output (2) is taken from the juncture of the Schottky diode (D3) and the second FET (T11). The circuit produces a low state output signal much closer to the lower reference voltage than prior circuits employing only two reference voltage levels ( + V, -V), with a correspondingly higher output voltage swing, noise margin and operating temperature range.

Fig.3.

## IMPROVED DIRECT COUPLED FET LOGIC

This invention relates to direct coupled field effect transistor (FET) logic circuits, particularly to those implemented in GaAs.

Direct coupled FET logic (DCFL) circuits have been proposed which are particularly useful in applying high speed GaAs to very large scale integrated (VLSI) circuitry, but are also applicable to other semiconductor materials such as silicon. In these circuits, the output of one logic stage is normally used as the input to another logic stage. Since the input element of any given stage is normally an enhancement type metal-semiconductor FET (MESFET), in which the gate voltage is limited to about 0.7 volts, there is an upper voltage limit of about 0.7 volts for the "high" output of any particular logic stage. In other words, the output high voltage ($V_{OH}$) cannot exceed about 0.7 volts. To achieve a large output voltage swing between high and low logic states, it is accordingly desirable that the output low voltage ($V_{OL}$) be kept as close to zero as possible. A low $V_{OL}$ increases the operating noise margin. Also, since the temperature range for a given stage is limited if its input voltage is high, keeping the $V_{OL}$ for the prior stage at a low level increases the temperature range for the next stage.

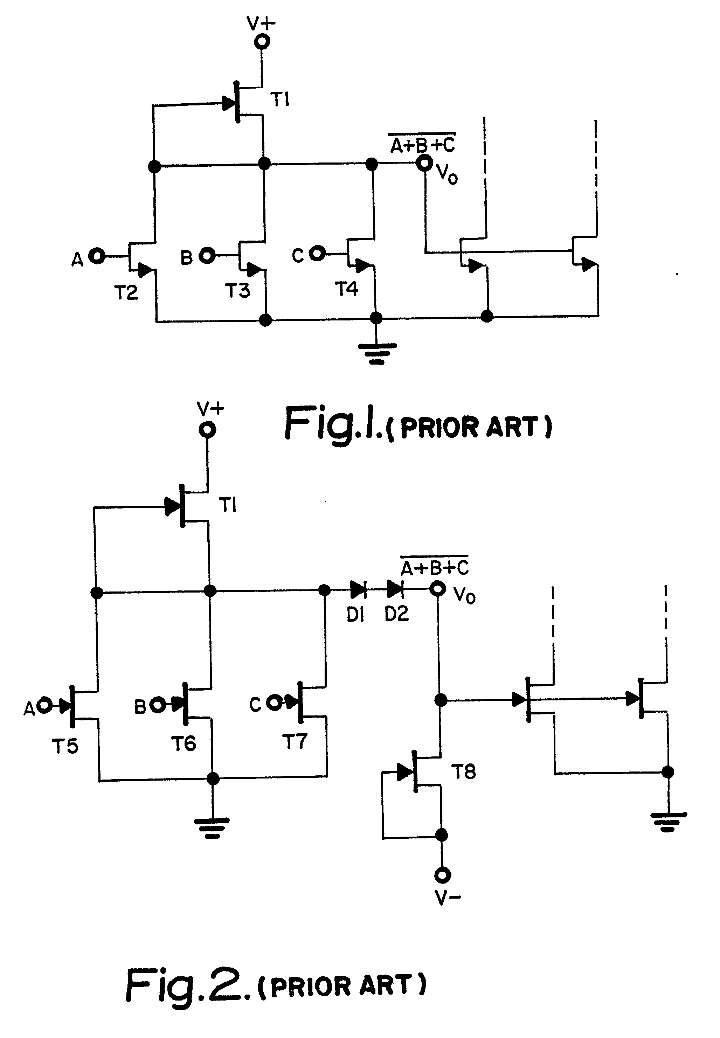

A number of known circuits are described in an article by Long et al., "Noise-Margin Limitations on Gallium-Arsenide VLSI", IEEE Journal of Solid-State Circuits. Vol. 23, No. 4, August 1988, pages 893-900. One such circuit, a NOR gate, is shown in FIG. 1. This is a popular circuit in which enhancement MESFETs are used for switch transistors, and a depletion MESFET serves as an active load current source. The depletion MESFET T1 has its gate and source connected together, so that it is always conducting. Its drain is connected to a positive voltage $V^+$ line so that the device functions as a current source. A three-input NOR gate is illustrated, with inputs A, B and C applied to the gates of enhancement switching MESFETs T2, T3 and T4, respectively. The sources of the three switching transistors are connected to ground. The gate output $V_O$ is taken from the drains of the switching transistors and applied to the next stage. The switching transistors T2-T4 may be either conducting or non-conducting, depending upon the input signals A, B and C applied to their gates.

When the input to one of the enhancement-type switching MESFETs is high, electrons collect in its channel and it becomes conductive. Its channel resistance is then lower than that of depletion-type MESFET T1, holding the output voltage $V_O$ closer to ground than $V^+$. When the circuit input is low, on the other hand, the switching MESFET is non-conductive and the conducting channel of T1 holds $V_O$ at a much higher level.

Since the circuit output is connected as an input to the gate of a MESFET in the next stage, $V_{OH}$ for the first stage is limited to about 0.7 volts because, if it attempted to go to a higher voltage, the input MESFET for the next stage would behave like a diode. $V_{OL}$ for this circuit, which is produced when high logic inputs are applied to each of the switching transistors T2-T4, is about 100 mV. Thus, the total output voltage swing between $V_{OH}$ and $V_{OL}$ is about 0.6 volts.

Another circuit which is described in the Long et al. article is shown in FIG. 2. In this circuit a third voltage reference line and associated circuitry is added to bring $V_{OL}$ closer to ground, and thereby make the output voltage swing closer to 0.7 volts. A depletion MESFET T1 is used as before to provide a current source from $V^+$. Depletion MESFETs T5, T6 and T7 are used as the switching transistors, with inputs A, B and C connected to their respective gates. The sources of T5, T6 and T7 are grounded, while their drains are connected through a pair of level shifting diodes d1 and D2 to an output line where they give the output voltage $V_O$. Another depletion MESFET T8 is connected from the output line to a negative voltage reference line $V^-$, with its gate and source connected together to function as a diode. The net result of adding level shifting diodes D1, D2 and pull-down MESFET T8 is to produce a logic swing of approximately 1.7 volts, with $v_{OH}$ again clamped at 0.7 volts by output loading. A one-diode version has also been proposed, in which the logic swing is reduced by 0.7 volts. In either case, however, three separate reference voltage levels are required ($V^+$, ground and $v^-$), which in general is undesirable as compared to the two voltage references of FIG 1.

A different circuit design approach for GaAs depletion-mode MESFET digital ICs, called capacitor diode-coupled FET logic (CDFL) has also been proposed. See Richard C. Eden, "Capacitor Diode FET Logic (CDFL) Circuit Approach for GaAs D-MESFET ICs", presented at IEEE Gallium Arsenide Integrated Circuit Symposium, October 1984. While this approach also showed improvements in terms of the output voltage swing, it again requires three separate reference voltage levels.

In view of the above problems, the object of the present invention is to provide a DCFL circuit which uses only two reference voltage levels, and yet achieves a higher output voltage swing than prior two-reference circuits, with an accompanying increase in noise margin and operating temperature range.

These objects are achieved with a basic inverter DCFL circuit in which a current source is supplied from a first voltage reference line, and a first (switching) FET has its drain-source circuit connected to conduct current from the current source to a second voltage reference line. A logic input is provided to the gate of the switching FET, while an output circuit interconnects the switching FET with an output line. The output circuit provides an output signal to the output line in response to the signal at the input line. It effectively decouples the output line from the drain-source voltage of the switching FET when a logic "high" signal is applied to the input line, and connects the output line instead to the second voltage reference line. With a logic "low" signal at the input line, an output "high" state is established in essentially the same manner as with the prior two-reference DCFL circuit.

In the preferred embodiment, the output circuit comprises a Schottky diode connected in series with a second (output) FET, with the Schottky diode connected between the switching and outputs FETs. The drain-source circuit of the output FET is connected to the second voltage reference line, while its gate is connected in common with the switching FET gate. The output line is connected to the juncture of the Schottky diode and output FET.

In operation, when a logic "high" input signal is applied, the Schottky diode establishes a voltage drop which is sufficient to hold the drain-source voltage of the output FET low enough so that most of the current from the current source is directed through the switching FET. With the output FET thus essentially non-conducting and yet with the same input drive as the switching FET, the output voltage is held via the output FET at a level very close to the second voltage reference level (ground). In contrast to the $V_{OL}$ of the prior two-voltage reference circuit, $V_{OL}$ for the present circuit is on the order of 1-2 mV, with a corresponding increase in the output voltage swing, noise margin and operating temperature range.

These and other features and advantages of the invention will be apparent to those skilled in the art from the following detailed description of a preferred embodiment, taken together with the accompanying drawings, in which:

FIGs. 1 and 2 are schematic diagrams of prior DCFL circuits, described above;

FIG. 3 is a schematic diagram of an inverter circuit using the DCFL approach of the present invention; and

FIG. 4 is a schematic diagram of a NOR gate which uses a number of the inverter circuits as shown in FIG. 3 as building blocks.

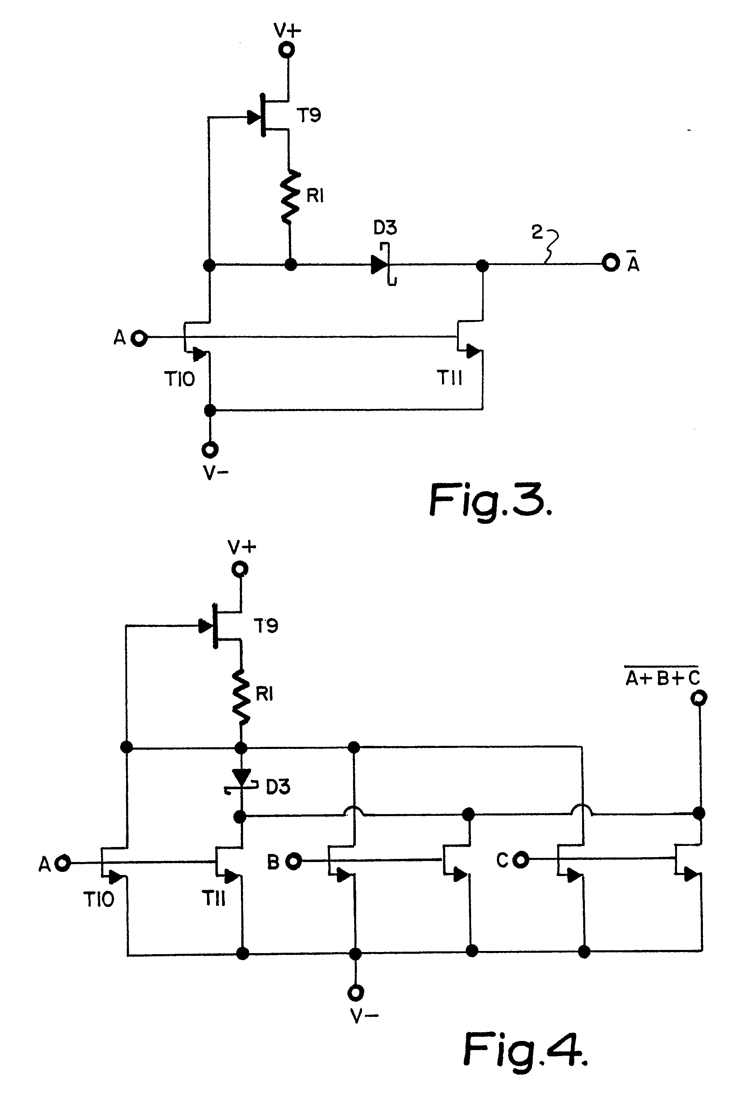

FIG. 3 shows a basic inverter circuit designed in accordance with the invention. This circuit can be used either on its own, or as a building block for more complex logic circuits. The current source is provided in a manner similar to prior circuits, with a depletion MESFET T9 having its drain connected to a positive voltage reference $v^+$, and its drain connected through a resistor R1 to a connection with its gate; R1 limits current changes resulting from processing variations. The $V^+$ voltage level is typically 3 or 5 volts above a lower reference voltage $V^-$, which may also be designated as ground.

The current source provides current to the drain of an enhancement-mode MESFET T10, the gate of which receives an input logic signal A and the source of which is connected to $V^-$. In addition to MESFET T10, an output circuit consisting of a Schottky diode D3 in series with another enhancement-mode MESFET T11 also receives current from the current source. D3, which is implemented as the gate-source circuit of an enhancement MESFET, conducts current from the current source to an output line 2. T11 has its drain connected to the output line 2, its gate connected in common with the gate of T10 to input A, and its source connected in common with the source of T10 to $V^-$.

With this circuit, the output signal on output line 2 is about 0.7 volts with a logic "low" signal at input A, the same as with the prior art circuit of FIG. 1. However, with a logic "high" at the input, the output circuit effectively decouples the output line 2 from the voltage across T10, forcing the output voltage to a very low level which is substantially equal to V-, differing therefrom by only about 1 or 2 mV. This is significantly lower than the $V_{OL}$ of prior art FIG. 1, and yields a correspondingly higher output voltage range. Another advantage relates to the fact that a high input voltage tends to limit the temperature range for a logic gate. Since the output line 2 would normally be connected as the input to a subsequent logic stage, keeping $V_{OL}$ low increases the temperature range of the next stage.

The manner in which the very low $V_{OL}$ is achieved with only two reference voltage levels will now be described. Assume that the input signal at input A is "high". In this condition, T10 sinks the current from the T9 current source. T10 is scaled large enough (about half the size of the MESFETs in the prior art FIG. 1 circuit) so that its drain-source voltage is less than about 100 mV. Since this is less than the voltage drop which must be developed across Schottky diode D3 for it to become conductive, virtually no current will be available to flow through the second MESFET T11. Thus, Schottky diode D3 acts as a voltage drop device which diverts current away from T11 and towards T10. Although essentially the only current through T11 is any leakage current which may be present, T11 is driven with the same gate input as T10. Accordingly, the drain voltage of T11 is pulled down to within a few millivolts of its source voltage V$^-$; for this purpose T11 does not have to be large in size, but rather can be equal in size to T10.

When the input is "low", the output voltage on line 2 is high, just as in the prior art FIG. 1 circuit except for an extra Schottky diode drop. However, the output $V_{OH}$ would still be clamped at about 0.7 volts by the input diode of the next logic gate.

The basic inverter of FIG. 3 can be used as a building block for more complicated logic circuits. One example, a NOR gate, is shown in FIG. 4. In this application, three of the new inverter circuits have a common output line, are supplied by a common current source T9, and are controlled by respective inputs A, B and C. A full complement of logic circuits can be constructed using the basic inverter of FIG. 3. An additional advantage of the invention is that $V_{OL}$ is independent of the number of logic inputs to any particular gate.

Perhaps the most promising application for the new logic circuitry is with GaAs, in which $V_{OH}$ is limited to 0.7 volts. However, the invention is also applicable to other semiconductor media, such as silicon, in which $V_{OH}$ is not limited in this manner. Other III-V or Group IV semiconductors would also be suitable, such as indium phosphide or diamond. In addition, while thus far circuits of this type have been successfully implemented in GaAs only with n-channel devices (p-channel devices are much slower), in principle the invention is applicable to p-channel as well as n-channel devices. Also, while the current source T9 is shown as a depletion device and the switching transistors T10, T11 as enhancement devices, T9 could theoretically be an enhancement device and T10, T11 depletion devices with an appropriate reversal of voltage polarities.

Accordingly, while a particular embodiment of the invention has been shown and described, numerous variations and alternate embodiments will occur to those skilled in the art, and the invention is to be limited only in terms of the appended claims.

## Claims

1. An improved direct coupled field effect transistor logic (DCFL) circuit, comprising:
first and second voltage reference lines for providing first and second voltage reference levels,
a current source supplied from the first voltage reference line,
a first field effect transistor (FET) having its drain-source circuit connected to conduct current from the current source to the second voltage reference line,
a second FET having its drain-source circuit connected in circuit between the current source and the second voltage reference line,
an input line connected to the gates of said first and second FETs,
an output line connected to the drain-source circuit of the FET and separated thereby from the second voltage reference line, and
circuit means diverting current source current away from the second FET when a logic "high" input signal is applied to the input line, thereby holding the voltage at the output line to a level close to the second voltage reference level.

2. The DCFL circuit of claim 1, said circuit means comprising a voltage drop circuit element connected between the drain-source circuit of the second FET and said current source, said voltage drop circuit element supporting a voltage drop sufficient to hold the drain-source voltage of the second FET at a level low enough to direct most of the current from the current source through the first FET.

3. The DCFL of claim 2, said voltage drop circuit element comprising a Schottky diode.

4. The DCFL circuit of claim 1, implemented as a gallium arsenide device.

5. The DCFL circuit of claim 1, wherein said FETS are metal-semiconductor FETs (MESFETs).

6. The DCFL circuit of claim 5, wherein said MESFETs are n-channel devices.

7. An improved direct coupled field effect transistor logic (DCFL) circuit, comprising:
first and second voltage reference lines for providing first and second voltage reference levels,
a current source supplied from the first voltage reference line,
a first field effect transistor (FET) having its drain connected to receive current from the current source and its source connected to the second voltage reference line,
a second FET having its source connected to the second voltage reference line,
an input line connected in common to the gates of said first and second FETs,
an output line connected to the drain of said second FET, and
a Schottky diode connected to conduct current from said current source to the drain of said second FET,
the dimensions of said first FET being selected so that, with a logic "high" input at the input line, the first FET's drain-source voltage is not substantially greater than the voltage across said Schottky diode, whereby the second FET's drain-source voltage and thus the output line voltage is held close to the second voltage reference level.

8. The DCFL circuit of claim 7, said first FET being scaled so that, with a logic "high" input at the input line, the first FET's drain-source voltage is substantially less than the turn-on voltage of the Schottky diode, thereby inhibiting the Schottky diode from turning on and supplying current to the second FET.

9. The DCFL circuit of claim 7, implemented as a gallium arsenide device.

10. The DCFL circuit of claim 7, wherein said FETS are metal-semiconductor FETs (MESFETs).

11. The DCFL circuit of claim 10, wherein said MESFETs are n-channel devices.

12. An improved direct coupled field effect transistor logic (DCFL) circuit, comprising:
first and second voltage reference lines for providing first and second voltage reference levels,
a current source supplied from the first voltage reference line,
a first field effect transistor (FET) having its drain-source circuit connected to conduct current from the current source to the second voltage reference line,
an input line connected to the gate of the first FET, an output line, and
an output circuit interconnecting the output line with the first FET and providing an output signal to said output line in response to the signal at the input line, said output circuit effectively decoupling the output line from the drain-source voltage of the first FET and connecting the output line to the second voltage reference line when a logic "high" signal is applied to the input line.

13. The DCFL circuit of claim 12, wherein said output circuit comprises a Schottky diode connected between the first FET and a second FET, the second FET having its drain-source circuit connected to the second voltage reference line and its gate connected in common with the first FET gate, said output line being connected to the juncture of said Schottky diode and said second FET.

14. The DCFL circuit of claim 12, implemented as a gallium arsenide device.

15. The DCFL circuit of claim 12, wherein said FETs are metal-semiconductor FETs (MESFETs).

16. The DCFL circuit of claim 15, wherein said MESFETs are n-channel devices.

Fig.I.(PRIOR ART)

Fig.2.(PRIOR ART)

V+

T9

RI

D3

2

Ā

A

T10

TII

V−

*Fig.3.*

V+

T9

RI

$\overline{A+B+C}$

D3

A

B

C

T10

TII

V−

*Fig.4.*